# EUROPÄISCHE PATENTSCHRIFT

(11) **EP 1 021 491 B1**
(45) Veröffentlichungstag und Bekanntmachung des Hinweises auf die Patenterteilung: **19.12.2001**
(21) Anmeldenummer: 98954228.7
(22) Anmeldetag: 25.09.1998
(51) Int. Cl.: C09G 1/02

(54) **POLIERMITTEL UND DIE VERWENDUNG DIESES POLIERMITTELS ZUM PLANARISIEREN EINES HALBLEITERSUBSTRATS**
POLISHING AGENT AND USE THEREOF TO PLANISH A SEMICONDUCTOR SUBSTRATE
AGENT DE POLISSAGE ET UTILISATION DE CET AGENT DE POLISSAGE POUR RENDRE PLANAIRE UN SUBSTRAT SEMI-CONDUCTEUR

(30) Priorität: 26.09.1997 DE 19742635
(43) Veröffentlichungstag der Anmeldung: 26.07.2000
(73) Patentinhaber: Infineon Technologies AG, 81669 München (DE)
(72) Erfinder: PUSCH, Catharina, F-75012 Paris (FR); SCHNEIDER, Germar, D-01109 Dresden (DE)
(74) Vertreter: Zedlitz, Peter, Dipl.-Inf.
(86) Internationale Anmeldenummer: DE9802863
(87) Internationale Veröffentlichungsnummer: WO9916842

(56) Entgegenhaltungen:
- EP-A- 0 811 666
- DE-A- 1 752 103
- DE-A- 2 008 243
- US-A- 4 226 623
- US-A- 4 274 907
- US-A- 4 702 904
- US-A- 4 769 073

## Beschreibung

Die Erfindung betrifft ein Poliermittel aus einer fluoridionenhaltigen Ätzlösung und in der Ätzlösung suspendierten Polierkörnern aus einem keramischen Material und die Verwendung dieses Poliermittels zum Planarisieren eines Halbleiter-substrats.

Es ist bekannt, fluoridhaltige Lösungen zum naßchemischen Ätzen von Halbleitersubstraten zu verwenden. Fluoridhaltige Lösungen eignen sich zum naßchemischen Ätzen einer Vielzahl von in der Halbleitertechnologie verwendeten Materialien, zum Beispiel von Siliziumdioxid SiO₂.

Beim chemisch-mechanischen Polieren (CMP) handelt es sich um ein Planarisierungsverfahren, das als ein chemisch unterstütztes mechanisches Polieren aufgefaßt werden kann. Das Poliermittel enthält neben den Polierkörnern (Abrasive) auch aktive chemische Zusätze.

Diese aktiven chemischen Zusätze sind auf das abzutragende Material abgestimmt. Um einen chemischen Angriff auf das zu planarisierende Substrat zu erzielen, wird eine basische Lösung eingesetzt. Die Basizität wird beispielsweise durch den Zusatz von Kalilauge (KOH), Tetramethylammoniumhydrid (TMAH), oder Ammoniak (NH₃) erzielt.

Der Einsatz eines derartigen Poliermittels beim chemisch-mechanischen Polieren hat den Nachteil, daß die Abtragerate gering ist.

Der Erfindung liegt die Aufgabe zugrunde, die Nachteile des Standes der Technik zu vermeiden. Insbesondere soll eine höhere Abtragerate erzielt werden, wobei eine möglichst hohe Gleichmäßigkeit des Abtragevorgangs erwünscht ist. Ferner soll eine Metallkontamination des zu planarisierenden Halbleitersubstrats vermieden werden. Außerdem sollen Materialien wie Silizide oder Keramiken bearbeitet werden können, die bisher nicht oder nur mit einer sehr geringen Abtragerate planarisierbar sind. Zusätzlich soll die Gefahr der Metallkontamination durch in der basischen Lösung enthaltene Metalle beseitigt werden.

Erfindungsgemäß wird diese Aufgabe dadurch gelöst, daß das keramische Material der Polierkörner mit einem Dotierstoff in einer Konzentration dotiert ist, die einen Phasenübergang des keramischen Materials in eine in der fluoridhaltigen Ätzlösung chemisch beständigere Phase bewirkt.

Die Erfindung sieht zunächst vor, ein Poliermittel so zu gestalten, daß die Poliermittellösung Fluoridionen enthält. In dieser Poliermittellösung befinden sich Polierkörner, die aus einem chemisch möglichst beständigen Material gebildet sind. 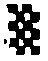 Chemisch möglichst beständiges Material 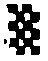 bedeutet in diesem Zusammenhang, daß das Material weitgehend inert ist und mit der Lösung bzw. dem Lösungsmittel chemisch nicht oder nur wenig reagiert.

Durch die in der Lösung enthaltenen Fluoridionen wird eine hohe Abtragerate beim Prozeß des chemisch-mechanischen Planarisierens erzielt. Außerdem werden auf der Oberfläche der Polierkörner angelagerte Verunreinigungen entfernt. Hierdurch wird die Oberfläche der Polierkörner glatter, so daß beim Poliervorgang die Entstehung von Mikrokratzern im zu planarisierenden Material vermieden wird. Die Entstehung von Mikrokratzern im zu planarisierenden Material wird außerdem dadurch vermieden, daß die Lösung des Poliermittels das zu planarisierende Material wegätzt.

Während die Fluoridionen das zu planarisierende Material chemisch angreifen, sind die Polierkörner chemisch beständig. Die chemische Beständigkeit der Polierkörner soll dabei so groß sein, daß sie bei den in der Lösung auftretenden Fluoridionenkonzentrationen nicht oder nur wenig in die Lösung übergehen.

Um die Beständigkeit der Polierkörner gegen die Fluoridionen weiter zu erhöhen ist das keramische Material durch die Zugabe eines oder mehrerer Dotierstoffe chemisch stabilisiert.

Eine besonders hohe chemische Beständigkeit der Polierkörner wird dadurch erzielt, daß die Konzentration des Dotierstoffs so groß ist, daß ein Phasenübergang des keramischen Materials erfolgt.

Besonders vorteilhaft ist es, daß das keramische Material Oxide eines oder mehrerer Übergangselemente enthält.

Um eine möglichst hohe chemische Beständigkeit der Polierkörner mit einer möglichst hohen mechanischen Beständigkeit zu verbinden, ist es zweckmäßig, daß die Übergangselemente aus der Gruppe Zirkonium, Hafnium, Niob, Tantal, Molybdän, Wolfram oder einem 3d-Übergangselement gewählt sind.

Insbesondere ist vorgesehen, daß die Polierkörner Zirkonium- oder Hafniumdioxid enthalten.

Eine besonders große Erhöhung der chemischen und mechanischen Beständigkeit läßt sich erzielen, wenn die Konzentration des Dotierstoffs in den Polierkörnern im Bereich von 2 Gew.-% bis 10 Gew.-% liegt.

Als Dotierstoffe eignen sich insbesondere Calcium, Strontium, Barium, Aluminium, Yttrium oder Selten-Erden-Elemente.

Bevorzugte Ausführungsarten sehen vor, daß der Dotierstoff Yttriumoxid ist und die Ätzlösung Flußsäure enthält.

Eine ausreichende chemische Beständigkeit der Polierkörner in der Lösung und eine hohe Ätzrate können dadurch erzielt werden, daß die Konzentration der Fluoridionen in der Lösung 0,1 Vol.-% bis 5 Vol.-% beträgt.

Besonders zweckmäßig ist es, daß die Konzentration der Polierkörner in der Lösung 0,03 Gew.-% bis 30 Gew.-% beträgt.

Noch vorteilhafter ist es, daß die Konzentration der Polierkörner in der Lösung 0,3 Gew.-% bis 3 Gew.-% beträgt. Bei diesem Konzentrationsbereich wird sowohl eine Sedimentation der Polierkörner vermieden als auch eine hohe Abtragerate erzielt.

Um eine hohe Abtragerate des zu planarisierenden Materials mit einer gleichzeitigen Vermeidung von Mikrokratzern zu verbinden, ist es vorteilhaft, daß der Durchmesser der Polierkörner 0,001 µm bis 5 µm beträgt, wobei sich Durchmesser von 0,5 µm bis 5 µm besonders eignen.

Zur Vermeidung von Mikrokratzern ist es besonders zweckmäßig, daß sich die Durchmesser von 95 % der Polierkörner um weniger als 10 % voneinander unterscheiden.

Weitere Vorteile und zweckmäßige Weiterbildungen der Erfindung ergeben sich aus den Unteransprüchen und der nachfolgenden Darstellung von bevorzugten Ausführungsbeispielen der Erfindung.

Nachfolgend werden Beispiele für erfindungsgemäße Poliermittel und deren Zusammensetzungen angegeben:

### Beispiel 1:

Das erfindungsgemäße Poliermittel enthält eine 0,5 %ige Flußsäure in wässeriger Lösung, wobei in dieser Lösung Polierkörner mit 3 % Gewichtsanteil suspendiert sind. Die Polierkörner bestehen dabei aus einer Zirkoniumdioxidverbindung aus 94,7 Gew.-% ZrO₂, das mit 5,3 Gew.-% Yttriumoxid Y₂O₃ dotiert ist.

Durch die 5 %ige Dotierung mit Yttriumoxid Y₂O₃ erfolgt ein Phasenübergang des Zirkoniumdioxids von der monoklinen in die tetragonale Phase. Während die monokline Phase von ZrO₂ in einer fluoridhaltigen Lösung chemisch nicht stabil ist, wird die tetragonale Phase von den Fluoridionen nicht angegriffen.

### Beispiel 2:

Das erfindungsgemäße Poliermittel enthält eine 0,5 %ige Flußsäure in wässeriger Lösung, wobei in dieser Lösung Polierkörner mit 3 % Gewichtsanteil suspendiert sind. Die Polierkörner bestehen hierbei aus einer Zirkoniumdioxidverbindung aus 92,0 Gew.-% ZrO₂, das mit 8,0 Gew.-% Yttriumoxid Y₂O₃ dotiert ist.

Durch die Dotierung mit Yttriumoxid Y₂O₃ in einer Konzentration zwischen 5,4 Gew.-% und 10 Gew.-% erfolgt ein Phasenübergang des Zirkoniumdioxids in die kubische Phase. Die kubische Phase von ZrO₂ zeichnet sich durch eine noch größere chemische Beständigkeit als die tetragonale Phase aus.

### Beispiel 3:

Das erfindungsgemäße Poliermittel enthält eine 0,5 %ige Flußsäure in wässeriger Lösung, wobei in dieser Lösung Polierkörner mit 3 % Gewichtsanteil suspendiert sind. Die Polierkörner bestehen aus einer Hafniumdioxidverbindung aus 95 Gew.-% HfO₂, das mit 5 Gew.-% Yttriumoxid Y₂O₃ dotiert ist.

Durch die Dotierung mit Yttriumoxid Y₂O₃ erfolgt ein Phasenübergang des Hafniumdioxids von der monoklinen in die tetragonale Phase. Während die monokline Phase von HfO₂ in einer fluoridhaltigen Lösung chemisch nicht stabil ist, wird die tetragonale Phase von den Fluoridionen nicht angegriffen.

### Beispiel 4:

Das erfindungsgemäße Poliermittel enthält eine 0,5 %ige Flußsäure in wässeriger Lösung, wobei in dieser Lösung Polierkörner mit 3 % Gewichtsanteil suspendiert sind. Die Polierkömer bestehen aus einer Hafniumdioxidverbindung aus 92,0 Gew.-% HfO₂, das mit 8,0 Gew.-% Yttriumoxid Y₂O₃ dotiert ist.

Durch die Dotierung mit Yttriumoxid Y₂O₃ in einer ausreichenden Konzentration erfolgt ein Phasenübergang des Hafniumdioxids in die kubische Phase. Die kubische Phase von HfO₂ zeichnet sich gleichfalls durch eine noch größere chemische Beständigkeit als die tetragonale Phase aus.

Diese Poliermittel können zum Polieren von Halbleiterschichten, insbesondere von siliziumdioxidhaltigen Schichten mit hohen Abtrageraten eingesetzt werden.

Die erfindungsgemäßen Poliermittel lassen sich aber auch zum Schleifen von harten Materialien verwenden. Hier sind neben den Refraktärmetallen Molybdän, Tantal, Titan und Wolfram vor allem die weiteren 3d-Übergangselemente, Metalloxide sowie Metall- und Übergangsmetall-Silizide zu nennen. Bei den 3d-Elementen hat die Planarisierbarkeit von Kupfer eine besonders große technische Bedeutung, weil es hierdurch möglich wird, Kupfer in den Herstellungsprozeß einer mikroelektronischen Schaltung zu integrieren.

Besonders überraschend ist, daß das erfindungsgemäße Poliermittel auch zum Planarisieren von oxidischen Supraleitern verwendet werden kann. Bisher mußten diese sehr harten Materialien in einem Trockenschleifverfahren mit einer Schleifscheibe, die Diamantsplitter enthält, planarisiert werden. Hierbei ist die Abtragerate sehr niedrig. Die Eignung eines fluoridhaltigen Poliermittels zum Planarisieren von oxidischen Supraleitern überrascht insbesondere deshalb, weil oxidische Supraleiter ihre supraleitenden Eigenschaften durch die Zufuhr von Chemikalien leicht verlieren können. Besonders die sogenannten Hochtemperatursupraleiter mit Übergangstemperaturen zur Supraleitung, die oberhalb der Verflüssigungstempratur von Stickstoff liegen, sind sonst gegen äußere chemische oder mechanische Einflüsse sehr empfindlich.

## Patentansprüche

1. Poliermittel aus einer fluoridionenhaltigen Ätzlösung und in der Ätzlösung suspendierten Polierkörnern aus einem keramischen Material,
**dadurch gekennzeichnet, daß**
das keramische Material der Polierkörner mit einem Dotierstoff in einer Konzentration dotiert ist, die einen Phasenübergang des keramischen Materials in eine in der fluoridhaltigen Ätzlösung chemisch beständigere Phase bewirkt.

2. Poliermittel nach Anspruch 1,
**dadurch gekennzeichnet,**
**daß** die Polierkörner Oxide eines oder mehrerer Übergangselemente enthalten.

3. Poliermittel nach Anspruch 2,
**dadurch gekennzeichnet,**
**daß** die Übergangselemente aus der Gruppe bestehend aus Zirkonium, Hafnium, Niob, Tantal, Molybdän, Wolfram oder einem 3d-Übergangselement ausgewählt sind.

4. Poliermittel nach Anspruch 3,
**dadurch gekennzeichnet, daß**
die Polierkörner Zirkoniumdioxid enthalten.

5. Poliermittel nach Anspruch 3,
**dadurch gekennzeichnet, daß**
die Polierkörner Hafniumdioxid enthalten.

6. Poliermittel nach einem der Ansprüche 1 bis 5,
**dadurch gekennzeichnet,**
**daß** die Konzentration des Dotierstoffs im keramischen Material im Bereich von 2 Gew.-% bis 10 Gew. -% liegt.

7. Poliermittel nach einem der Ansprüche 1 bis 6,
**dadurch gekennzeichnet,**
**daß** der Dotierstoff aus der Gruppe Calcium, Strontium, Barium, Aluminium, Yttrium oder einem Selten-Erden-Element ausgewählt ist.

8. Poliermittel nach Anspruch 7,
**dadurch gekennzeichnet,**
**daß** der Dotierstoff Yttriumoxid ist.

9. Poliermittel nach einem der Ansprüche 1 bis 8,
**dadurch gekennzeichnet, daß**
die Ätzlösung Flußsäure enthält.

10. Poliermittel nach einem der Ansprüche 1 bis 9,
**dadurch gekennzeichnet,**
**daß** die Konzentration der Fluoridionen in der Ätzlösung 0,1 Vol.-% bis 5 Vol.-% beträgt.

11. Poliermittel nach einem der Ansprüche 1 bis 10,
**dadurch gekennzeichnet,**
**daß** die Konzentration der Polierkörner in der Ätzlösung 0,03 Gew.-% bis 30 Gew.-% beträgt.

12. Poliermittel nach Anspruch 11,
**dadurch gekennzeichnet,**
**daß** die Konzentration der Polierkörner in der Ätzlösung 0,3 Gew.-% bis 3 Gew.-% beträgt.

13. Poliermittel nach einem der Ansprüche 1 bis 12,
**dadurch gekennzeichnet,**
**daß** der Durchmesser der Polierkömer 0,001 µm bis 5 µm beträgt.

14. Poliermittel nach einem der Ansprüche 1 bis 13,
**dadurch gekennzeichnet,**
**daß** sich die Durchmesser von 95 % der Polierkörner um weniger als 10 % voneinander unterscheiden.

15. Verwendung eines Poliermittels nach einem der Ansprüche 1 bis 14 zum Planarisieren von Halbleitersubstraten oder Substraten aus 3d-Übergangselementen, Siliziden, Refraktärmetallen, Metalloxiden oder von oxidischen Supraleitern.

## Claims

1. Polishing means comprising a fluoride ion-containing etching solution and polishing grains which are suspended in the etching solution and comprise a ceramic material,
**characterized in that**
the ceramic material of the polishing grains is doped with a dopant in a concentration which brings about a phase transition of the ceramic material into a phase which is more chemically resistant in the fluoride-containing etching solution.

2. Polishing means according to Claim 1,
**characterized**
**in that** the polishing grains contain oxides of one or more transition elements.

3. Polishing means according to Claim 2,
**characterized**
**in that** the transition elements are selected from the group comprising zirconium, hafnium, niobium, tantalum, molybdenum, tungsten or a 3d transition element.

4. Polishing means according to Claim 3,
**characterized in that**
the polishing grains contain zirconium dioxide.

5. Polishing means according to Claim 3,
**characterized in that**
the polishing grains contain hafnium dioxide.

6. Polishing means according to one of Claims 1 to 5,
**characterized**
**in that** the concentration of the dopant in the ceramic material is in the range from 2% by weight to 10% by weight.

7. Polishing means according to one of Claims 1 to 6,
**characterized**
**in that** the dopant is selected from the group consisting of calcium, strontium, barium, aluminium, yttrium or a rare-earth element.

8. Polishing means according to Claim 7,
**characterized**
**in that** the dopant is yttrium oxide.

9. Polishing according to one of Claims 1 to 8,
**characterized in that**
the etching solution contains hydrofluoric acid.

10. Polishing means according to one of Claims 1 to 9,
**characterized**
**in that** the concentration of the fluoride ions in the etching solution is from 0.1% by volume to 5% by volume.

11. Polishing means according to one of Claims 1 to 10,
**characterized**
**in that** the concentration of the polishing grains in the etching solution is from 0.03% by weight to 30% by weight.

12. Polishing means according to Claim 11,
**characterized**
**in that** the concentration of the polishing grains in the etching solution is from 0.3% by weight to 3% by weight.

13. Polishing means according to one of Claims 1 to 12,
**characterized**
**in that** the diameter of the polishing grains is from 0.001 µm to 5 µm.

14. Polishing means according to one of Claims 1 to 13,
**characterized**
**in that** the diameters of 95% of the polishing grains differ from one another by less than 10%.

15. Use of a polishing means according to one of Claims 1 to 14 for planarizing semiconductor substrates or substrates comprising 3d transition elements, silicides, refractory metals, metal oxides or for planarizing oxidic superconductors.

## Revendications

1. Agent de polissage constitué d'une solution d'attaque contenant des ions fluorures et, en suspension dans la solution d'attaque, de grains de polissage en une matière céramique,
**caractérisé**
**en ce que** la matière céramique des grains de polissage est dopée par une substance de dopage en une concentration qui provoque une transition de phase de la matière céramique pour la faire passer en une phase plus résistance chimiquement à la solution d'attaque contenant des fluorures.

2. Agent de polissage suivant la revendication 1,
**caractérisé**
**en ce que** les grains de polissage contiennent des oxydes d'un élément de transition ou de plusieurs éléments de transition.

3. Agent de polissage suivant la revendication 2,
**caractérisé**
**en ce que** les éléments de transition sont choisis dans le groupe constitué du zirconium, de l'hafnium, du niobium, du tantale, du molybdène, du tungstène ou d'un troisième élément de transition.

4. Agent de polissage suivant la revendication 3,
**caractérisé**
**en ce que** les grains de polissage contiennent du dioxyde de zirconium.

5. Agent de polissage suivant la revendication 3,
**caractérisé**
**en ce que** les grains de polissage contiennent du dioxyde d'hafnium.

6. Agent de polissage suivant l'une des revendications 1 à 5,
**caractérisé**
**en ce que** la concentration de la substance de dopage dans la matière céramique est de l'ordre de 2% en poids à 10% en poids.

7. Agent de polissage suivant l'une des revendications 1 à 6,
**caractérisé**
**en ce que** la substance de dopage est choisie dans le groupe du calcium, du strontium, du baryum, de l'aluminium, de l'yttrium ou d'un élément des terres rares.

8. Agent de polissage suivant la revendication 7,
**caractérisé**
**en ce que** la substance de dopage est de l'oxyde d'yttrium.

9. Agent de polissage suivant l'une des revendications 1 à 8,
**caractérisé**
**en ce que** la solution d'attaque contient de l'acide fluorhydrique.

10. Agent de polissage suivant l'une des revendications 1 à 9,
**caractérisé**
**en ce que** la concentration des ions fluorures dans la solution d'attaque est comprise entre 0,1% en volume et 5% en volume.

11. Agent de polissage suivant l'une des revendications 1 à 10,
**caractérisé**
**en ce que** la concentration des grains de polissage dans la solution d'attaque est comprise entre 0,03% en poids et 30% en poids.

12. Agent de polissage suivant la revendication 11,
**caractérisé**
**en ce que** la concentration des grains de polissage dans la solution d'attaque est comprise entre 0,3% en poids et 3% en poids.

13. Agent de polissage suivant l'une des revendications 1 à 12,
**caractérisé**
**en ce que** le diamètre des grains de polissage est compris entre 0,001 µm et 5 µm.

14. Agent de polissage suivant l'une des revendications 1 à 13,
**caractérisé**
**en ce que** les diamètres de 95% des grains de polissage se distingue les uns des autres de moins de 10%.

15. Utilisation d'un agent de polissage suivant l'une des revendications 1 à 14, pour planariser des substrats semi-conducteurs ou des substrats en éléments de transition 3d, en siliciures, en métaux réfractaires, en oxydes métalliques ou des supraconducteurs oxydés.
